# EUROPEAN PATENT SPECIFICATION

(11) **EP 3 614 415 B1**
(45) Date of publication and mention of the grant of the patent: **16.12.2020**
(21) Application number: 19191264.1
(22) Date of filing: 12.08.2019
(51) Int. Cl.: H01J 37/32, C23C 16/32, C23C 14/06

(54) **BORON CARBIDE SINTERED BODY AND ETCHER INCLUDING THE SAME**
BORCARBID-SINTERKÖRPER UND ÄTZER DAMIT
CORPS FRITTÉ À BASE DE CARBURE DE BORE ET GRAVEUR LE COMPRENANT

(30) Priority: 13.08.2018 KR 20180094196; 16.01.2019 KR 20190005482
(43) Date of publication of application: 26.02.2020
(73) Proprietor: SKC Solmics Co., Ltd., Pyeongtaek-si, Gyeonggi-do 17784 (KR)
(72) Inventor: Hwang, Sung Sic, 02535 Seoul (KR); Lee, Jae Bum, 17845 Gyeonggi-do (KR); Oh, Jun Rok, 06100 Seoul (KR); Min, Kyoung Yeol, 17079 Gyeonggi-do (KR); Kim, Kyung In, 18486 Gyeonggi-do (KR); Kang, Jung Kun, 17779 Gyeonggi-do (KR)
(74) Representative: Isarpatent

(56) References cited:
- JP-A- 2000 247 743
- JP-A- 2010 107 340
- US-A1- 2008 227 618
- US-A1- 2012 298 910
- US-B1- 6 258 741
- US-B1- 6 352 611

## Description

### BACKGROUND

### 1. Field

The present disclosure relates to a boron carbide sintered body and an etcher including the same.

### 2. Description of the Background

Boron carbide (B₄C) is a wear resistant ceramic material that has the third highest hardness after diamond and cubic boron nitride (BN). Boron carbide is a highly hard and inelastic material known for its high melting point (2447 °C), high strength (28-35 GPa, Knoop hardness), low density (2.21 g/cm³), and high Young's modulus (450-470 GPa). Boron carbide can be used for thermocouples operating in molten metal for a long period of time due to its high thermoelectromotive force and good chemical stability. In addition, boron carbide has long been used as a neutron absorbing and shielding material in nuclear power plants due to its high ability to absorb neutrons.

Boron carbide (B₄C) is used as a polishing material or a material for cutting tools. Sintering aids such as Y₂O₃, SiC, Al₂O₃, TiB₂, AlF₃, and W₂B₅ can be used for sintering of boron carbide (B₄C) powders. However, such sintering aids are known to form secondary phases. Secondary phases formed during sintering with sintering aids may have a bad influence on the physical properties of boron carbide (B₄C).

The above information is presented as background information only to assist with an understanding of the present disclosure. No determination has been made, and no assertion is made, as to whether any of the above might be applicable as prior art with regard to the disclosure. JP 2000-247743 and US-B1-6258741 both disclose a corrosion-resistant member for use in a plasma etcher, the member being formed of sintered boron carbide. US-B1-6352611 discloses a ceramic composition of matter for the wafer mounting ring of a process kit in a reactor chamber wherein substrates are etched in a plasma of an etchant gas. The ceramic composition of matter contains boron carbide.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, a boron carbide sintered body i, as defined in claim 1, includes necked boron carbide-containing particles wherein the thermal conductivity of the boron carbide sintered body at 400 °C is 27 W/m·K or less and the ratio of the thermal conductivity of the boron carbide sintered body at 25 °C to that of the boron carbide sintered body at 800 °C is 1:0.2 to 1:3.

The particles may have a particle diameter (D₅₀) of 1.5 µm or less.

The boron carbide sintered body may have a surface roughness (Ra) of 0.1 µm to 1.2 µm.

The boron carbide sintered body may not, in use, form particles upon contact with fluorine ions in a plasma etcher.

The boron carbide sintered body may not, in use, form particles upon contact with chlorine ions in a plasma etcher.

The boron carbide sintered body may have a porosity of 3% or less.

The boron carbide sintered body may have an average surface or cross-sectional pore diameter of 5 µm or less.

The area of pores having an average surface or cross-sectional diameter of 10 µm or more accounts for 5% or less of the area of all pores in the boron carbide sintered body.

The etch rate, in use, of the boron carbide sintered body may be 55% or less of that of silicon.

The etch rate, in use, of the boron carbide sintered body may be 70% or less of that of CVD-SiC.

An element for an etcher may include the boron carbide sintered body.

In another general aspect, an etcher i, as defined in claim 10, includes the boron carbide sintered body.

The etcher may be a plasma etcher.

In another general aspect, a boron carbide sintered body includes necked boron carbide-containing particles wherein the relative density of the boron carbide sintered body measured by the Archimedes method is 90% or greater.

The relative density of the boron carbide sintered body measured by the Archimedes method may be 95% or greater.

The boron carbide sintered body may include 500 ppm or less of metallic by-products.

The boron carbide sintered body may be relatively inert relative to iridium upon contact with fluorine ions or chlorine ions in a plasma etcher.

Other features and aspects will be apparent from the following detailed description, the drawings, and the claims.

### BRIEF DESCRIPTION OF THE DRAWINGS

Fig. 1 shows (a) and (b) surface microscopy images of sintered bodies produced in Production Examples 2 and 3, respectively.
Fig. 2 shows (a) and (b) surface microscopy images of sintered bodies produced in Production Examples 5 and 6, respectively.
Fig. 3 shows (a) and (b) surface microscopy images of sintered bodies produced in Production Examples 7 and 8, respectively.
Fig. 4 shows (a) and (b) surface microscopy images of a sintered body produced in Production Example 5 before and after etching, respectively.
Fig. 5 shows (a) and (b) surface microscopy images of a sintered body produced in Production Example 8 before and after etching, respectively.

Throughout the drawings and the detailed description, the same reference numerals refer to the same elements. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of this disclosure. For example, the sequences of operations described herein are merely examples, and are not limited to those set forth herein, but may be changed as will be apparent after an understanding of this disclosure, with the exception of operations necessarily occurring in a certain order. Also, descriptions of features that are known in the art may be omitted for increased clarity and conciseness.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of this disclosure. Hereinafter, while embodiments of the present disclosure will be described in detail with reference to the accompanying drawings, it is noted that examples are not limited to the same.

Throughout the specification, when an element, such as a layer, region, or substrate, is described as being "on," "connected to," or "coupled to" another element, it may be directly "on," "connected to," or "coupled to" the other element, or there may be one or more other elements intervening therebetween. In contrast, when an element is described as being "directly on," "directly connected to," or "directly coupled to" another element, there can be no other elements intervening therebetween.

As used herein, the term "and/or" includes any one and any combination of any two or more of the associated listed items; likewise, "at least one of" includes any one and any combination of any two or more of the associated listed items.

In the present specification, the term "combination of" included in Markush type description means mixture or combination of one or more elements described in Markush type and thereby means that the disclosure includes one or more elements selected from the Markush group.

Although terms such as "first," "second," and "third" may be used herein to describe various members, components, regions, layers, or sections, these members, components, regions, layers, or sections are not to be limited by these terms. Rather, these terms are only used to distinguish one member, component, region, layer, or section from another member, component, region, layer, or section. Thus, a first member, component, region, layer, or section referred to in examples described herein may also be referred to as a second member, component, region, layer, or section without departing from the teachings of the examples.

Spatially relative terms such as "above," "upper," "below," and "lower" may be used herein for ease of description to describe one element's relationship to another element as shown in the figures. Such spatially relative terms are intended to encompass different orientations of the device in use or operation in addition to the orientation depicted in the figures. For example, if the device in the figures is turned over, an element described as being "above" or "upper" relative to another element will then be "below" or "lower" relative to the other element. Thus, the term "above" encompasses both the above and below orientations depending on the spatial orientation of the device. The device may also be oriented in other ways (for example, rotated 90 degrees or at other orientations), and the spatially relative terms used herein are to be interpreted accordingly.

The terminology used herein is for describing various examples only, and is not to be used to limit the disclosure. The articles "a," "an," and "the" are intended to include the plural forms as well, unless the context clearly indicates otherwise. The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Due to manufacturing techniques and/or tolerances, variations of the shapes shown in the drawings may occur. Thus, the examples described herein are not limited to the specific shapes shown in the drawings, but include changes in shape that occur during manufacturing.

The features of the examples described herein may be combined in various ways as will be apparent after an understanding of this disclosure. Further, although the examples described herein have a variety of configurations, other configurations are possible as will be apparent after an understanding of this disclosure.

Herein, it is noted that use of the term "may" with respect to an example, for example, as to what an example may include or implement, means that at least one example exists in which such a feature is included or implemented while all examples are not limited thereto.

As used herein, the term "boron carbide" refers to all compounds based on boron and carbon. The boron carbide may optionally include one or more additives and/or doping materials. For example, the boron carbide may include boron and carbon in a total amount of at least 90 mole%, at least 95 mole%, at least 98 mole%, or at least 99 mole%. The boron carbide may exist as a single phase, a multiple phase or a mixed phase thereof. The single-phase boron carbide is intended to include both a stoichiometric phase of boron and carbon and a non-stoichiometric phase of boron and carbon that deviate from the stoichiometric composition. The multiple-phase boron carbide refers to a mixture of at least two compounds based on boron and carbon in a predetermined ratio. As used herein, the term "boron carbide" is intended to include a solid solution containing impurities added to single- or multiple-phase boron carbide and a mixture containing inevitable impurities incorporated during preparation of boron carbide. The impurities may be, for example, iron, copper, chromium, nickel, and aluminum.

An object of the present disclosure is to provide a boron carbide sintered body with excellent characteristics and an etcher including, at least in part, the boron carbide sintered body.

The present disclosure will now be described in more detail.

A boron carbide sintered body according to an embodiment of the present disclosure includes necked boron carbide-containing particles wherein the boron carbide sintered body has a thermal conductivity of 27 W/m·K or less at 400 °C.

The ratio of the thermal conductivity of the boron carbide sintered body at 25 °C (HC₂₅) to that of the boron carbide sintered body at 800 °C (HC₈₀₀) may be 1:0.2-3 (i.e., 1:0.2 to 1:3). For example, the ratio of HC₂₅:HC₈₀₀ may be 1:0.26-1 or 1:0.26-0.6.

The thermal conductivity of the boron carbide sintered body is maintained in a constant range despite a considerable change in the temperature of an environment in which the sintered body is used. Thus, even when the boron carbide sintered body is used in an environment where a temperature variation is large, the thermal properties of the boron carbide sintered body can be maintained relatively constant and subsequent processes can proceed stably. The controlled porosity of boron carbide sintered body can be used to control the thermal conductivity of the sintered body. Alternatively, at least one additive such as silicon carbide or silicon can be used to control the thermal conductivity of the sintered body.

The thermal conductivity of the sintered body may be about 60 W/m·K or less, about 40 W/m·K or less, about 30 W/m·K or less or about 27 W/m·K or less at a temperature selected from the range of 25 to 800 °C. The thermal conductivity of the sintered body may be at least about 4 W/m·K or at least about 5 W/m·K at a temperature selected from the range of 25 to 800 °C.

The thermal conductivity of the sintered body may be about 80 W/m·K or less or about 31 W/m·K or less at 25 °C. The thermal conductivity of the sintered body may be at least about 20 W/m·K or at least about 22 W/m·K at 25 °C.

The thermal conductivity of the sintered body may be about 70 W/m·K or less or about 22 W/m·K or less at 400 °C. The thermal conductivity of the sintered body may be at least about 7 W/m·K or at least about 8 W/m·K at 400 °C.

The thermal conductivity of the sintered body may be about 50 W/m·K or less or about 16 W/m·K or less at 800 °C. The thermal conductivity of the sintered body may be at least about 5 W/m·K or at least about 6 W/m·K at 800 °C.

The thermal conductivity of the sintered body allows the sintered body to have good etch resistance.

The sintered body may include sintered and necked boron carbide-containing particles having a particle diameter (D₅₀) of 1.5 µm or less. Details of the sintering and necking processes will not be described here because such a description appears in methods for producing sintered bodies below.

The roughness Ra of the boron carbide sintered body may be from about 1.0 µm to about 1.2 µm. The roughness Ra of the sintered body may be reduced to about 0.2 µm to about 0.4 µm after polishing. The roughness Ra of the sintered body can be measured using a 3-dimensional measuring machine. The low surface roughness of the boron carbide sintered body indicates a smoother surface of the boron carbide sintered body and ensures excellent physical properties of the boron carbide sintered body even when the boron carbide sintered body is applied, in part, to an etcher or is applied, in part or in whole, to an element for an etcher.

The porosity of the boron carbide sintered body may be about 10% or less. For example, the porosity of the boron carbide sintered body may be about 5% or less. For example, the porosity of the boron carbide sintered body may be about 3% or less. For example, the porosity of the boron carbide sintered body may be about 2% or less. For example, the porosity of the boron carbide sintered body may be about 1% or less. For example, the porosity of the boron carbide sintered body may be about 0.5% or less. For example, the porosity of the boron carbide sintered body may be about 0.1% or less. For example, the porosity of the boron carbide sintered body may be about 0.001% or more. The low porosity of the sintered body indicates the presence of small carbon areas between the particles and ensures good corrosion resistance of the sintered body.

The average cross-sectional pore diameter of the boron carbide sintered body may be 5 µm or less. Here, the average pore diameter is defined as the diameter of a circle with the same area as the cross-sectional area of the pore. The average pore diameter may be 3 µm or less. For example, the average pore diameter may be 1 µm or less. The area of pores having a diameter of 10 µm or more accounts for 5% or less of the area of all pores in the boron carbide sintered body. This indicates that the boron carbide sintered body has a relatively dense structure in which the pores are well distributed as a whole. Due to its dense structure, the boron carbide sintered body has improved corrosion resistance.

The boron carbide sintered body may contain 500 ppm or less, 300 ppm or less, 100 ppm or less, 10 ppm or less or 1 ppm or less of metallic by-products (impurities). The boron carbide sintered body may be substantially free of metallic by-products (impurities).

The boron carbide sintered body has the advantage that it does not form particles (particulate impurities) upon reaction with halogen ions in an etcher. The particles refer to materials with a particle diameter of 1 µm or more. For example, the boron carbide sintered body may not form particles upon reaction with fluorine ions in a plasma etcher. For example, the boron carbide sintered body may not form particles upon reaction with chlorine ions in a plasma etcher. This feature distinguishes the boron carbide sintered body from sintered bodies using iridium that react with halogen ions to form particulate impurities. That is, the boron carbide sintered body is relatively inert with respect to halogen ions in an etcher, for example, compared to iridium. Thus, the boron carbide sintered body is advantageously applied to an etcher.

The boron carbide sintered body has a low etch rate. For example, when the etch rate of silicon (Si, single-crystal silicon, produced by the growing method) is defined as 100%, the boron carbide sintered body may have an etch rate of 55% or less, for example, 10 to 50% or even 20 to 45%. Here, the etch rate is evaluated based on a thickness reduction rate (%). For example, the etch rate is calculated by the proportion of the material (boron carbide sintered body; Si, single-crystal silicon, produced by the growing method; etc.) etched when exposed for 280 hours in a plasma etcher operated at an RF power of 2,000 W.

The etch rate of the boron carbide sintered body is much lower than that of chemical vapor deposited silicon carbide (CVD-SiC), indicating better etch resistance of the boron carbide sintered body. For example, when the etch rate of CVD-SiC is defined as 100%, the etch rate of the boron carbide sintered body may be not higher than 70%.

The boron carbide sintered body may have high, medium or low electrical resistance.

For example, the high-resistance boron carbide sintered body may have a resistivity of about 10 Ω·cm to about 103 Ω·cm. Here, the high-resistance boron carbide sintered body is composed mainly of boron carbide and may include silicon carbide or silicon nitride as a sinterability enhancer.

For example, the medium-resistance boron carbide sintered body may have a resistivity of about 1 Ω cm to about 10 Ω cm. Here, the medium-resistance boron carbide sintered body is composed mainly of boron carbide and may include boron nitride as a sinterability enhancer.

For example, the low-resistance boron carbide sintered body may have a resistivity of about 10⁻¹ Ω cm to about 10⁻² Ω cm. Here, the low-resistance boron carbide sintered body is composed mainly of silicon carbide and may include carbon as a sinterability enhancer.

For example, the low-resistance boron carbide sintered body may have a resistivity of 5.0 Ω cm or less, 1.0 Ω cm or less or 8×10⁻¹ Ω cm or less.

The boron carbide sintered body of the present disclosure has low etch rate and a microstructure whose cross section is uniform as a whole and has reduced carbon areas. Due to these excellent characteristics, the boron carbide sintered body of the present disclosure has great utility in many applications such as corrosion resistant members.

An etcher according to a further embodiment of the present disclosure includes, at least in part, the boron carbide sintered body. For example, the boron carbide sintered body may be applied to a wall of a plasma reactor, a nozzle for processing gas or a shower head for processing gas.

An element for an etcher according to another embodiment of the present disclosure may include, at least in part, the boron carbide sintered body or may be composed of the boron carbide sintered body. For example, the boron carbide sintered body may be applied to consumables such as focus rings and edge rings. The use of the boron carbide sintered body reduces the number of defects during etching in an etcher while ensuring long-term use of the consumables, achieving improved efficiency of the etcher.

A method for producing the boron carbide sintered body according to another embodiment of the present disclosure includes a primary molding step and a sintered body formation step. The method may further include a granulation step before the primary molding step. The method may further include a sintered body processing step after the sintered body formation step.

The granulation step includes mixing raw materials including boron, carbon, boron carbide or a mixture thereof with a solvent to prepare a slurry of the raw materials (slurrify-procedure) and drying the slurry of the raw materials to prepare spherical granules of the raw materials (granulation- procedure).

The raw materials may include boron carbide and a sinterability enhancer.

The boron carbide is represented by B₄C and may be in the form of a powder.

The boron carbide powder may have an average particle diameter (D₅₀) of about 1.5 µm or less, about 0.3 µm to about 1.5 µm, or about 0.4 µm to about 1.0 µm. The boron carbide powder may have an average particle diameter (D₅₀) of about 0.4 µm to about 0.8 µm. If the average particle diameter of the boron carbide powder is excessively large, the resulting sintered body may have low density and poor corrosion resistance. Meanwhile, if the average particle diameter of the boron carbide powder is excessively small, poor workability or low productivity may result.

The sinterability enhancer included in the raw materials serves to improve the physical properties of the boron carbide sintered body. For example, the sinterability enhancer may be selected from the group consisting of carbon, boron oxide, silicon, silicon carbide, silicon oxide, boron nitride, silicon nitride, and combinations thereof.

The sinterability enhancer may be present in an amount of about 0.1% to about 30% by weight, 1% to 25% by weight, or 5 to 25% by weight, based on the total weight of the raw materials. The presence of the sinterability enhancer in an amount less than 0.1% by weight may lead to an insignificant improvement in sintering characteristics. Meanwhile, the presence of the sinterability enhancer in an amount exceeding 30% by weight may lead to a deterioration in the strength of the sintered body.

The boron carbide (for example, in the form of a powder) makes up the remainder of the raw materials.

The sinterability enhancer may include boron oxide, carbon or a combination thereof.

Carbon as the sinterability enhancer may be added in the form of a resin. The resin may also be used after carbonization. The carbonization may be performed by any suitable process for carbonizing polymer resins.

Carbon as the sinterability enhancer may be used in an amount of 1 to 30% by weight, 5 to 30% by weight, 8 to 28% by weight, or 13 to 23% by weight. The use of carbon as the sinterability enhancer in the amount defined above increases the necking between the particles, makes the size of the particles relatively large, and leads to a relatively high relative density of the boron carbide sintered body. However, if the content of the carbon exceeds 30% by weight, the residual carbon may form carbon areas, resulting in a reduction in the hardness of the boron carbide sintered body.

Alternatively, boron oxide may be used as the sinterability enhancer. The boron oxide is represented by B₂O₃ and chemically reacts with carbon present in pores of the sintered body to form boron carbide and assists in discharging residual carbon, which makes the sintered body dense.

Alternatively, a combination of boron oxide and carbon may be used as the sinterability enhancer. The use of boron oxide and carbon can further increase the relative density of the sintered body, can reduce the presence of carbon areas in the pores, and can improve the compactness of the sintered body.

The boron oxide and the carbon may be used in a weight ratio ranging from 1:0.8 to 1:4, from 1:1.2 to 1:3, or from 1:1.5 to 1:2.5. Within this range, the relative density of the sintered body can be improved. For example, the raw materials may contain 1 to 9% by weight of the boron oxide and 5 to 15% by weight of the carbon. In this case, the sintered body may have a high degree of compaction and few defects.

The sinterability enhancer may have a melting point in the range of about 100 °C to about 1000 °C. For example, the additive may have a melting point in the range of about 150 °C to about 800 °C or about 200 °C to about 400 °C. Within this range, the additive can easily diffuse between the boron carbide particles during sintering of the raw materials.

In the slurrify-procedure, the solvent is used to slurry the raw materials. The solvent may be an alcohol such as ethanol or water. The solvent may be used in an amount of about 60% to about 80% by volume, based on the total volume of the slurry.

The raw materials can be slurried by ball milling. For example, polymer balls may be used for ball milling. The slurrying may be performed for about 5 hours to about 20 hours.

The granulation- procedure can be performed by spraying the slurry such that the solvent is removed by evaporation and the raw materials are granulated. The granulated particles of the raw materials have a round shape as a whole and are relatively constant in size.

The particle diameter (D₅₀) of the granulated-raw materials may be in the range of about 0.3 to about 1.5 µm, about 0.4 µm to about 1.0 µm or about 0.4 µm to about 0.8 µm.

This range facilitates filling of the granulated particles of the raw materials in a mold and ensures improved workability of the granulated particles of the raw materials during the subsequent primary molding step to produce a green body.

In the primary molding step, the raw materials including boron carbide are molded into a green body. For example, the molding may be performed by filling the raw materials in a mold (for example, a rubber mold) and pressing the filled raw materials. For example, the molding may be performed by cold isostatic pressing (CIP).

The primary molding by cold isostatic pressing is made efficient when a pressure of about 100 MPa to about 200 MPa is applied.

The size and shape of the green body are appropriately determined taking into consideration the application of the sintered body.

Preferably, the green body is designed to be slightly larger in size than the final sintered body. Since the strength of the sintered body is higher than that of the green body, it may be desired to shorten the time required to process the sintered body. For this purpose, the method may further include a sintered body processing step which removes unnecessary portions from the green body to process the shape of the green body after the primary molding step.

In the sintered body formation step, the green body is carbonized and sintered to produce the boron carbide sintered body.

The green body can be carbonized at a temperature of about 600 °C to about 900 °C. The carbonization enables the removal of a binder and unnecessary impurities from the green body.

For the subsequent sintering, the carbonized green body can be maintained at a temperature of about 1800 °C to about 2500 °C for about 10 hours to about 20 hours. The sintering allows for growth and necking of the particles of the raw materials and densifies the sintered body.

The sintering can be performed with a temperature profile consisting of heating, maintenance, and cooling. For example, the temperature profile consists of primary heating, maintenance of the primary heating temperature, secondary heating, maintenance of the secondary heating temperature, tertiary heating, maintenance of the tertiary heating temperature, and cooling.

The heating rate may be from about 1 °C/min to about 10 °C/min. For example, the heating rate may be from about 2 °C/min to about 5 °C/min.

For the sintering, a temperature of about 100 °C to about 250 °C may be maintained for about 20 minutes to about 40 minutes. For the sintering, a temperature zone of about 250 °C to about 350 °C may be maintained for about 4 hours to about 8 hours. For the sintering, a temperature zone of about 360 °C to about 500 °C may be maintained for about 4 hours to about 8 hours. When the temperature zone is maintained for the predetermined time, the additive can easily diffuse and the phase of the boron carbide sintered body is made uniform.

For the sintering, a temperature zone of about 1800 °C to about 2500 °C may be maintained for about 10 hours to about 20 hours. In this case, the sintered body can be made stronger.

The cooling rate may be from about 1 °C/min to about 10 °C/min. For example, the cooling rate may be from about 2 °C/min to about 5 °C/min.

The resulting boron carbide sintered body may be subjected to additional processing such as surface processing and/or shape processing.

The surface processing is a process for planarizing the surface of the sintered body and may be performed by any suitable process for ceramic planarization.

The shape processing refers to a process for removing or cutting off portions of the sintered body to obtain an intended shape. The shape processing may be performed by electrical discharge machining because the high degree of compaction and high strength of the boron carbide sintered body should be taken into consideration. For example, the shape processing may be performed by electrical discharge wire machining.

For example, the sintered body is immersed in a water bath, a direct current power source is connected to the sintered body and a wire, and target portions of the sintered body are cut off by a reciprocating wire. The voltage of the direct current power source may be from about 100 volts to about 120 volts. The machining rate may be from about 2 mm/min to about 7 mm/min, the wire speed may be from about 10 rpm to about 15 rpm, the tension of the wire may be from about 8 G to about 13 G, and the diameter of the wire may be from about 0.1 mm to about 0.5 mm.

The characteristics of the resulting sintered body are the same as those described above.

A method for producing the boron carbide sintered body according to another embodiment of the present disclosure includes the steps of preparation, arrangement, and molding.

In the preparation step, raw materials including boron carbide are poured into a cavity of a molding die.

The cavity may have a cylindrical or disc shape. Alternatively, the cavity may have a shape in which two or more cylinders or discs with different sizes and heights are stacked on one another. For example, the cavity may include a first cavity and a second cavity formed on each other and having different sizes and heights such that they are distinguishable from each other. The height of the first cavity may be greater than that of the second cavity. The size of the first cavity may be smaller than that of the second cavity.

The boron carbide is represented by B₄C and may be in the form of a powder.

A boron carbide powder may be used as one of the raw materials and at least one additive may be used as another raw material. Alternatively, only a boron carbide powder may be used as a raw material. The content of boron carbide in the boron carbide powder is not limited and may be as high as 99.9% by weight, greater than 99.9% by weight, or as low as 95% to less than 99.9% by weight.

The boron carbide powder may have an average particle diameter (D₅₀) of about 1.5 µm or less, about 0.3 µm to about 1.5 µm or about 0.4 µm to about 1.0 µm. The boron carbide powder may have an average particle diameter (D₅₀) of about 0.4 µm to about 0.8 µm. The use of the boron carbide powder makes the boron carbide sintered body dense with few pores.

The additive forms a boron carbide solid solution in some or all portions of the boron carbide sintered body to impart functionality to the boron carbide sintered body.

The additive may be a sinterability enhancer for the purpose of improving the sintering characteristics of the boron carbide sintered body. The sinterability enhancer may be selected from the group consisting of carbon, boron oxide, silicon, silicon carbide, silicon oxide, boron nitride, silicon nitride, and combinations thereof. The sinterability enhancer may include boron oxide, carbon or a combination thereof. Carbon as the sinterability enhancer may be added in the form of a resin. The resin may also be used after carbonization. The carbonization may be performed by any suitable process for carbonizing polymer resins.

For example, the sinterability enhancer may be present in an amount less than about 30% by weight, about 0.001 % to about 30% by weight, 0.1% to 25% by weight or 5% to 25% by weight, based on the total weight of the raw materials. The presence of the sinterability enhancer in an amount exceeding 30% by weight may lead to a deterioration in the strength of the final sintered body.

The die may be an assembly consisting of two or more separate pieces.

The molding die can be made of a material such as graphite that has relatively high strength at high temperatures. Thus, a high sintering pressure can be applied to the molding die. If needed, a reinforcement portion may be added to reinforce the molding die.

In the arrangement step, the die is loaded into a sintering furnace or chamber and pressing members are set. Any sintering furnace or chamber capable of creating a high temperature and high pressure environment in which the boron carbide sintered body can be produced may be used without limitation.

In the molding step, a sintering temperature and a sintering pressure are applied to the die to form the boron carbide sintered body from the raw materials.

The die has a shape corresponding to the desired boron carbide sintered body. A cavity is previously formed in the die so that the desired shape of the product can be relatively easily created.

The sintering temperature may be from about 1800 to about 2500 °C or about 1800 to about 2200 °C. The sintering pressure may be from about 10 to about 110 MPa, from about 15 to about 60 MPa or about 17 to about 30 MPa. The molding at the sintering temperature and the sintering pressure ensures the production of the boron carbide sintered body with high quality in an efficient manner.

The sintering time may be from 0.5 to 10 hours, 0.5 to 7 hours or 0.5 to 6 hours.

The sintering time is very short compared to that in a sintering process performed at ambient pressure. Despite the short sintering time, the sintered body has quality equal to or higher than that produced by a sintering process performed at ambient pressure.

The molding step may be carried out in a reducing atmosphere. In this case, possible reaction products (such as boron oxide) between the boron carbide powder and oxygen in air are reduced, and as a result, the boron carbide sintered body contains a larger amount of boron carbide.

The molding step may be carried out while a spark is generated in gaps between the particles in the sintering furnace. In this case, pulsed electrical energy is applied to the die through electrodes connected to corresponding pressing members. The application of pulsed electrical energy in the molding step enables the production of the dense sintered body in a short time.

The maximum sintering temperature zone in the molding step may be from about 1900 °C to about 2200 °C and may be maintained for about 2 hours to about 5 hours. Here, the pressure applied to the die may be from about 15 MPa to about 60 MPa. For example, the pressure applied to the die may be from about 17 MPa to about 30 MPa.

For example, the molding step may be carried out in a spark plasma sintering system. In this case, simultaneously with or separately from heating of a chamber of the sintering system, a pressure may be applied to the die to sinter the raw materials. Here, electrical energy may be applied to the chamber to promote sintering of the raw materials. For example, a pulsed direct current may be applied to the chamber.

A method for producing the boron carbide sintered body according to another embodiment of the present disclosure includes preparing a substrate and gaseous materials and depositing a boron carbide layer on the substrate.

The boron carbide sintered body can be produced by deposition. For example, the boron carbide sintered body may be produced over the entire surface of a substrate by a vapor deposition process such as bulk CVD. For example, the boron carbide sintered body may be produced through a series of operations: deposition of CVD boron carbide (BC) on a substrate, removal of the substrate, shape processing, polishing, measurement, and cleaning.

First, a boron carbide film is formed on a substrate (for example, mainly graphite or SiC) by CVD. The substrate may be removed by physical vapor deposition of sufficient amounts of gaseous materials on the substrate.

Then, the boron carbide sintered body is processed into a predetermined shape by mechanical machining and is polished to make its surface smooth. Thereafter, the boron carbide sintered body is checked for quality and contaminants are removed therefrom. Some of the operations may be omitted or one or more other operations may be added without departing from the scope of the present disclosure.

A boron source gas and a carbon source gas may be used as the gaseous materials for the CVD process. The boron source gas may contain a gas selected from the group consisting of B₂H₆, BCl₃, BF₃, and combinations thereof. The carbon source gas may contain CF₄.

For example, the boron carbide sintered body may be produced by deposition of B₂H₆ as a boron precursor at a temperature of 500 to 1500 °C in a chemical vapor deposition system.

Various deposition or coating processes may be applied to the production of the boron carbide sintered body. Any process for coating a thick boron carbide layer on a substrate may be used without limitation and examples thereof include physical vapor deposition, room temperature spray, aerosol spray, and plasma spray.

According to the physical vapor deposition process, for example, a boron carbide target may be sputtered in an argon (Ar) gas atmosphere. The coating layer formed by the physical vapor deposition process can be referred to as a thick PVD boron carbide coating layer.

According to the room temperature spray process, a boron carbide powder may be pressurized at room temperature such that it is sprayed on a base material through a plurality of discharge holes to form a boron carbide sintered body layer. The boron carbide powder may be sprayed in the form of granules under vacuum. According to the cold spray process, a boron carbide powder may be sprayed on a base material through a plurality of discharge holes under a flow of compressed gas at a temperature higher by approximately 60 °C than room temperature to form a boron carbide sintered body in the form of a coating layer. According to the aerosol spray process, a boron carbide powder is mixed with a volatile solvent such as polyethylene glycol or isopropyl alcohol and the resulting aerosol is sprayed on a base material to form a boron carbide sintered body. According to the plasma spray process, a boron carbide powder is injected into a hot plasma jet and the molten powder is sprayed on a base material to form a boron carbide sintered body.

The physical properties of the resulting boron carbide sintered body are the same as those described above and the method enables the production of the boron carbide sintered body in a short time.

The present disclosure will be explained in more detail with reference to the following examples. However, these examples are merely illustrative to assist in understanding the present disclosure and are not intended to limit the scope of the present disclosure.

### 1. Production Examples 1-8: Production of boron carbide sintered bodies

Boron carbide particles (particle size D₅₀ = 0.7 µm) and sinterability enhancers as raw materials were mixed with a solvent by ball milling in a slurry blender to prepare slurries of the raw materials. The amounts of the raw materials are shown in Table 1. Each of the slurries was spray dried to granulate the raw materials.

The granulated raw materials were filled in a rubber mold, loaded into a CIP device, and pressurized to prepare a green body. The green body was subjected to carbonization to remove contaminants and pressureless sintering in a sintering furnace to produce a sintered body.

### 2. Production Example 9: Production of boron carbide sintered body

Boron carbide particles (particle size D₅₀ = 0.7 µm) were filled in a die, loaded into a pressing machine, and sintered under the temperature, pressure, and time conditions shown in Table 1 to produce a sintered body.

The amounts of the raw materials used in Production Examples 1-9 and the sintering temperature and time conditions are summarized in Table 1.

**[Table 1]**

| Production Example No. | Sinterability enhancer 1* (wt%) | Sinterability enhancer 2** (wt%) | Boron carbide powder (wt%) | Sintering temperature (°C) | Sintering time (h) | Pressure (MPa) |
|---|---|---|---|---|---|---|
| 1 | 0 | 0 | 100 | 2380 | 10 | Ambient pressure |
| 2 | 5 | 0 | Remainder | 2380 | 10 | Ambient pressure |
| 3 | 15 | 0 | Remainder | 2380 | 10 | Ambient pressure |
| 4 | 20 | 0 | Remainder | 2380 | 10 | Ambient pressure |
| 5 | 20 | 0 | Remainder | 2380 | 15 | Ambient pressure |
| 6 | 10 | 0 | Remainder | 2380 | 15 | Ambient pressure |
| 7 | 0 | 10 | Remainder | 2380 | 15 | Ambient pressure |
| 8 | 10 | 5 | Remainder | 2380 | 15 | Ambient pressure |
| 9 | 0 | 0 | 100 | 1950 | 5 | 25 |

| | | | | | | |
|---|---|---|---|---|---|---|
| * Carbon was used as the sinterability enhancer 1. ** Boron oxide was used as the sinterability enhancer 2. | | | | | | |

### 3. Comparative Examples 1 and 2

SiC prepared by CVD was used as Comparative Example 1. For example, a chemical vapor deposition silicon carbide (CVD-SiC) layer was formed on one side surface of a silicon carbide layer as a base layer. The composition of the CVD-SiC was the same as that of the base layer.

Single-crystal silicon was used as Comparative Example 2.

### Evaluation of physical properties

### (1) Relative density evaluation and surface observation

The relative densities (%) of the sintered bodies were measured by the Archimedes method. The results are shown in Table 2. The surface characteristics of the sintered bodies were observed with an electron microscope. The images are shown in the accompanying drawings. In Table 2, "-" means not measured.

**[Table 2]**

| Production Example No. | Total amount of sinterability enhancers | Sintering temperature (°C) | Sintering time (h) | Relative density (%) | Kind of sinterability enhancer | Surface observation |
|---|---|---|---|---|---|---|
| 1 | 0 | 2380 | 10 | 63.77 | Not used | - |
| 2 | 5 | 2380 | 10 | 77.38 | Carbon | (a) of Fig. 1 |
| 3 | 15 | 2380 | 10 | 90.4 | Carbon | (b) of Fig. 1 |
| 4 | 20 | 2380 | 10 | 90.76 | Carbon | |
| 5 | 20 | 2380 | 15 | 93.11 | Carbon | (a) of Fig. 2 |
| 6 | 10 | 2380 | 15 | 94.14 | Carbon | (b) of Fig. 2 |
| 7 | 10 | 2380 | 15 | 95.42 | Boron oxide | (a) of Fig. 3 |
| 8 | 15 | 2380 | 15 | 97.43 | Mixture | (b) of Fig. 3 |
| 9 | 0 | 1950 | 5 | 99.9 | Not used | - |

As can be seen from the results in Table 2, the relative densities of the sintered bodies produced under the same conditions in Production Examples 1-4 increased as the amount of carbon used as the sinterability enhancer increased to 20 wt%. That is, the use of carbon as the sinterability enhancer in amounts ranging from 12 to 23 wt% achieved particularly high relative densities.

The results of Production Examples 5 and 6 were compared with those of Production Examples 1-4. As a result, it was found that the relative density increased with increasing sintering time. It was also found that the reduced amount of the sinterability enhancer led to further improvement of sintering characteristics.

The boron carbide sintered body of Production Example 9, which was produced by sintering under pressure without using any sinterability enhancer, showed excellent sintering characteristics.

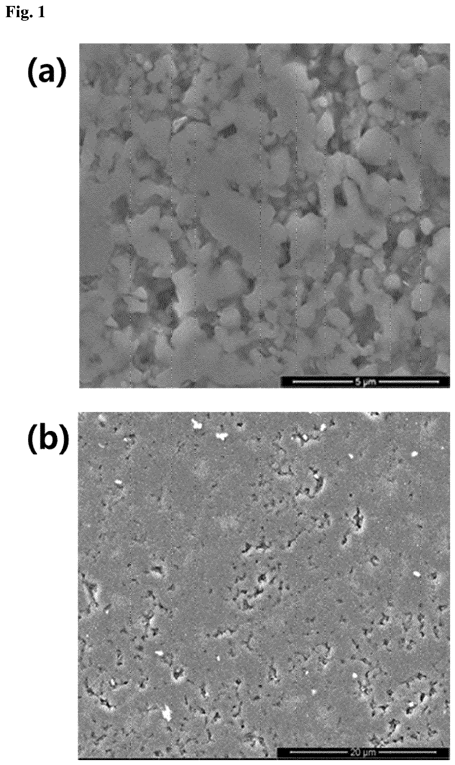

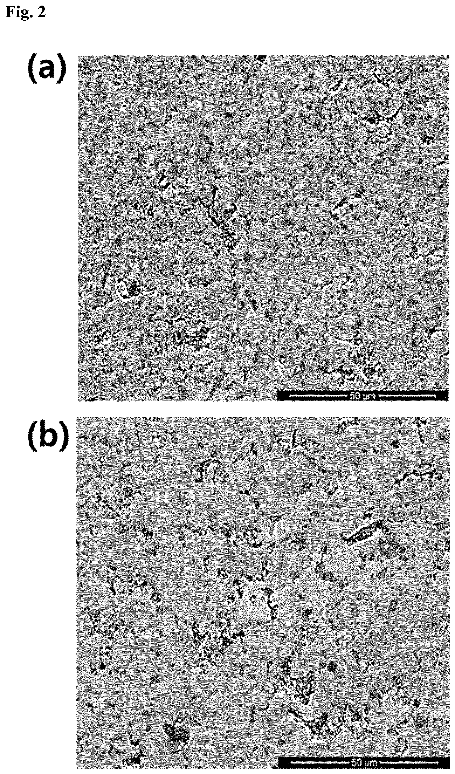

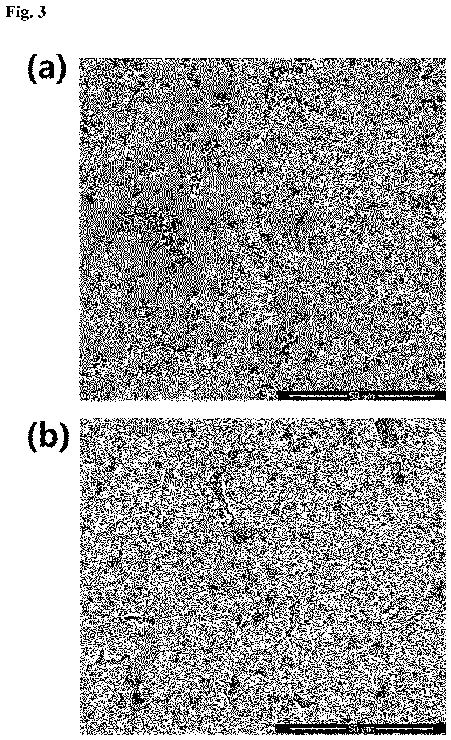

Fig. 1 shows (a) and (b) surface microscopy images of sintered bodies produced in Production Examples 2 and 3, respectively. Fig. 2 shows (a) and (b) surface microscopy images of sintered bodies produced in Production Examples 5 and 6, respectively. Fig. 3 shows (a) and (b) surface microscopy images of sintered bodies produced in Production Examples 7 and 8, respectively. Referring to Figs. 1-3, the particles became necked and the sintered body became dense with increasing relative density.

### (2) Thermal conductivity, resistance, and etch rate

Thermal conductivities (W/m·K) were measured using a laser flash apparatus (LFA457 MICROFLASH ® by NETZCH).

Resistivities (Ω cm) were measured using a surface resistance meter (MCP-T610 by MITSUBISHI CHEMICAL).

Etch rates (%) were measured at the same temperature under the same atmosphere in a plasma etcher operated at an RF power of 2000 W.

These physical properties are shown in Tables 3 and 4.

**[Table 3]**

| Production Example No. | Thermal conductivity at 25 °C | Thermal conductivity at 400 °C | Thermal conductivity at 800 °C | Ratio of HC25:HC800 | Surface observation |
|---|---|---|---|---|---|
| 1 | - | - | - | - | - |
| 2 | - | - | - | - | (a) of Fig. 1 |
| 3 | - | - | - | - | (b) of Fig. 1 |
| 4 | - | - | - | - | - |
| 5 | 31.665 | 22.481 | 16.625 | 1: 0.525 | (a) of Fig. 2 |
| 6 | 30.269 | 21.144 | 15.684 | 1: 0.518 | (b) of Fig. 2 |
| 7 | - | - | - | - | (a) of Fig. 3 |
| 8 | - | - | - | - | (b) of Fig. 3 |
| 9 | 23.659 | 9.419 | 7.497 | 1: 0.269 | - |
| Comparative Example 1 | 265.526 | 116.373 | 68.312 | 1: 0.257 | - |
| Comparative Example 2 | - | - | - | - | - |

**[Table 4]**

| Production Example No. | Resistivity (Ω·cm) | Etch rate (%) (1) | Etch rate (%) (2) | Determination of whether particles were formed upon contact with fluorine ions | Surface observation before and after etching (1) |
|---|---|---|---|---|---|
| 5 | 3.21×10⁻¹ | 86.22 | - | × | Before etching: (a) of Fig. 4 |
| | | | | | After etching: (b) of Fig. 4 |
| 6 | 1.85×10⁻¹ | - | - | × | - |
| 8 | 6.832×10⁻¹ | 61.54 | 40 | × | Before etching: (a) of Fig. 5 |
| | | | | | After etching: (b) of Fig. 5 |
| 9 | 1.706×10⁰ | 59.39 | 36 | × | - |
| Comparative Example 1 | - | 100 | 62 | × | - |
| Comparative Example 2 | - | - | 100 | × | - |

As can be seen from the above experimental results, the relative densities of the boron carbide sintered bodies produced in Production Examples 2-8 were higher than that of the boron carbide sintered body produced without using any sinterability enhancer in Production Example 1. However, it was found that the relative density was not proportional to the amount of the same sinterability enhancer. Another experiment (not shown) revealed that the relative density of a boron carbide sintered body produced using 25 wt% of carbon was low compared to those of the boron carbide sintered bodies produced using 20 wt% of carbon.

The relative density of the boron carbide sintered body produced using boron oxide as the sinterability enhancer in Production Example 7 was higher than that of the boron carbide sintered body produced using the same amount of carbon in Production Example 6. In addition, the relative density of the boron carbide sintered body produced using a combination of carbon and boron oxide in Production Example 8 was much higher than that of the boron carbide sintered bodies produced under the same sintering conditions in Production Examples 5-7. Surface observation revealed that carbon areas were uniformly spread throughout the entire surface of the boron carbide sintered body of Production Example 8, and as a result, relatively large carbon areas were not present in the pores or, even if present, their number was very few.

The thermal conductivities of the samples thus produced were in the predetermined range. The much lower etch rates of the samples than silicon carbide and silicon indicate better corrosion resistance of the samples. Particularly, the boron carbide sintered body of Production Example 9, which was produced by a method different from that for the production of the other boron carbide sintered bodies, showed the best etch resistance. The boron carbide sintered body of Production Example 8 showed better results in terms of etch resistance than the boron carbide sintered bodies of Production Examples 1-7, which were produced in a similar manner to that in Production Example 8. These results are believed to be much better than those of CVD-SiC and Si.

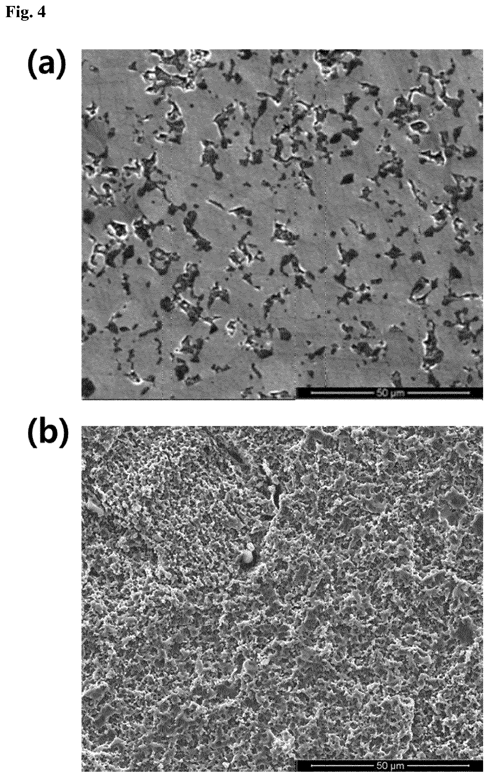

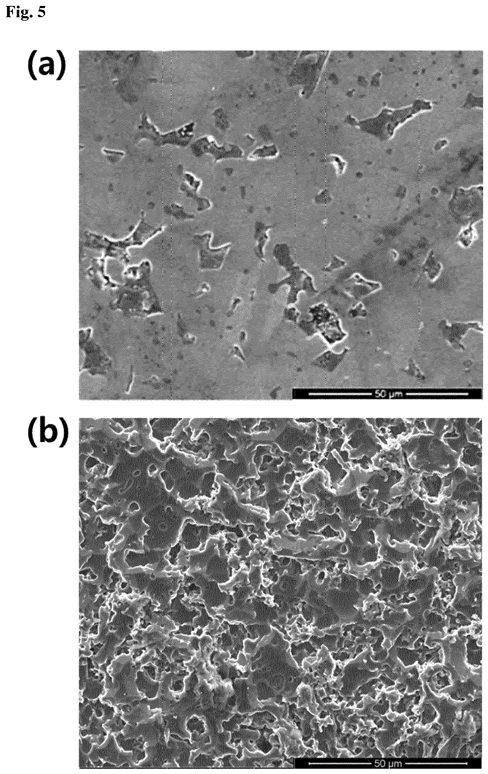

Fig. 4 shows (a) and (b) surface microscopy images of a sintered body produced in Production Example 5 before and after etching, respectively. Fig. 5 shows (a) and (b) surface microscopy images of a sintered body produced in Production Example 8 before and after etching, respectively.

The boron carbide sintered body of the present disclosure has relatively constant thermal conductivity and low etch rate (i.e., good corrosion resistance).

In addition, the boron carbide sintered body of the present disclosure does not substantially form particles upon reaction with halogen ions such as fluorine or chlorine ions. Therefore, the boron carbide sintered body of the present disclosure can be readily applied, at least in part, to an etcher such as a plasma etcher. Furthermore, the boron carbide sintered body of the present disclosure has low etch rate with its proper thermal conductivity which can be controlled by varying reaction conditions, and leads to improved etch efficiency for an etcher.

While specific examples have been shown and described above, it will be apparent after an understanding of this disclosure that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents. Therefore, the scope of this disclosure is defined not by the detailed description, but by the claims and all variations within the scope of the claims are to be construed as being included in this disclosure. The invention is defined by the claims.

## Claims

1. A boron carbide sintered body comprising necked boron carbide-containing particles wherein the thermal conductivity of the boron carbide sintered body at 400 °C is 27 W/m·K or less and the ratio of the thermal conductivity of the boron carbide sintered body at 25 °C to that of the boron carbide sintered body at 800 °C is 1:0.2 to 1:3.

2. The boron carbide sintered body according to claim 1, wherein the particles comprise a particle diameter (D₅₀) of 1.5 µm or less.

3. The boron carbide sintered body according to claim 1, wherein the boron carbide sintered body comprises a surface roughness (Ra) of 0.1 µm to 1.2 µm.

4. The boron carbide sintered body according to claim 1, wherein the boron carbide sintered body comprises a porosity of 3% or less.

5. The boron carbide sintered body according to claim 1, wherein the boron carbide sintered body comprises an average surface or cross-sectional pore diameter of 5 µm or less.

6. The boron carbide sintered body according to claim 1, wherein the area of pores comprising an average surface or cross-sectional diameter of 10 µm or more accounts for 5% or less of the area of all pores in the boron carbide sintered body.

7. The boron carbide sintered body according to claim 1, wherein, in use, the boron carbide sintered body does not form particles upon contact with fluorine ions or chlorine ions in a plasma etcher.

8. The boron carbide sintered body according to claim 1, wherein, in use, the etch rate of the boron carbide sintered body is 55% or less of that of silicon.

9. The boron carbide sintered body according to claim 1, wherein, in use, the etch rate of the boron carbide sintered body is 70% or less of that of CVD-SiC.

10. An etcher comprising the boron carbide sintered body according to claim 1.

11. The etcher according to claim 10, wherein the etcher is a plasma etcher.

## Patentansprüche

1. Borcarbid-Sinterkörper, der eingeschnürte borcarbidhaltige Partikel umfasst, wobei die Wärmeleitfähigkeit des Borcarbid-Sinterkörpers bei 400 °C maximal 27 W/m-K beträgt und das Verhältnis der Wärmeleitfähigkeit des Borcarbid-Sinterkörpers bei 25 °C zu der des Borcarbid-Sinterkörpers bei 800 °C 1:0,2 bis 1:3 beträgt.

2. Borcarbid-Sinterkörper nach Anspruch 1, wobei die Partikel einen Partikeldurchmesser (D₅₀) von 1,5 µm maximal aufweisen.

3. Borcarbid-Sinterkörper nach Anspruch 1, wobei der Borcarbid-Sinterkörper eine Oberflächenrauigkeit (Ra) von 0,1 µm bis 1,2 µm aufweist.

4. Borcarbid-Sinterkörper nach Anspruch 1, wobei der Borcarbid-Sinterkörper einen Porenanteil von maximal 3 % aufweist.

5. Borcarbid-Sinterkörper nach Anspruch 1, wobei der Borcarbid-Sinterkörper einen durchschnittlichen Oberflächen- oder Querschnittsporendurchmesser von maximal 5 µm aufweist.

6. Borcarbid-Sinterkörper nach Anspruch 1, wobei die Fläche von Poren mit einem durchschnittlichen Oberflächen- oder Querschnittsdurchmesser von 10 µm oder mehr maximal 5 % der Fläche aller Poren in dem Borcarbid-Sinterkörper ausmacht.

7. Borcarbid-Sinterkörper nach Anspruch 1, wobei der Borcarbid-Sinterkörper während des Gebrauchs bei Kontakt mit Fluor- oder Chlorionen in einer Plasma-Ätzvorrichtung keine Partikel bildet.

8. Borcarbid-Sinterkörper nach Anspruch 1, wobei die Ätzrate des Borcarbid-Sinterkörpers während des Gebrauchs maximal 55 % der Ätzrate von Silizium beträgt.

9. Borcarbid-Sinterkörper nach Anspruch 1, wobei die Ätzrate des Borcarbid-Sinterkörpers während des Gebrauchs maximal 70 % der Ätzrate von CVD-SiC beträgt.

10. Ätzvorrichtung, umfassend den Borcarbid-Sinterkörper nach Anspruch 1.

11. Ätzvorrichtung nach Anspruch 10, wobei die Ätzvorrichtung eine Plasma-Ätzvorrichtung ist.

## Revendications

1. Corps fritté en carbure de bore comprenant des particules contenant du carbure de bore à striction, dans lequel la conductivité thermique du corps fritté en carbure de bore à 400 °C est de 27 W/m·K ou moins et le rapport entre la conductivité thermique du corps fritté en carbure de bore à 25 °C et celle du corps fritté en carbure de bore à 800 °C est de 1:0,2 à 1:3.

2. Corps fritté en carbure de bore selon la revendication 1, dans lequel les particules comprennent un diamètre de particule (D₅₀) de 1,5 µm ou moins.

3. Corps fritté en carbure de bore selon la revendication 1, dans lequel le corps fritté en carbure de bore comprend une rugosité de surface (Ra) de 0,1 µm à 1,2 µm.

4. Corps fritté en carbure de bore selon la revendication 1, dans lequel le corps fritté en carbure de bore comprend une porosité de 3 % ou moins.

5. Corps fritté en carbure de bore selon la revendication 1, dans lequel le corps fritté en carbure de bore comprend un diamètre moyen de pore de surface ou de coupe de 5 µm ou moins.

6. Corps fritté en carbure de bore selon la revendication 1, dans lequel l'aire de pores comprenant un diamètre moyen de pore de surface ou de coupe de 10 µm ou plus représente 5 % ou moins de l'aire de la totalité des pores dans le corps fritté en carbure de bore.

7. Corps fritté en carbure de bore selon la revendication 1, dans lequel, en utilisation, le corps fritté en carbure de bore ne forme pas de particules lors d'un contact avec des ions fluor ou des ions chlore dans un appareil de gravure par plasma.

8. Corps fritté en carbure de bore selon la revendication 1, dans lequel, en utilisation, la vitesse de gravure du corps fritté en carbure de bore est de 55 % ou moins celle du silicium.

9. Corps fritté en carbure de bore selon la revendication 1, dans lequel, en utilisation, la vitesse de gravure du corps fritté en carbure de bore est de 70 % ou moins celle du SiC en CVD.

10. Appareil de gravure comprenant le corps fritté en carbure de bore selon la revendication 1.

11. Appareil de gravure selon la revendication 10, dans lequel l'appareil de gravure est un appareil de gravure par plasma.
